# DEMANDE DE BREVET EUROPEEN

(11) **EP 1 050 911 A1**
(43) Date de publication de la demande: **08.11.2000**
(21) Numéro de dépôt: 00401187.0
(22) Date de dépôt: 28.04.2000
(51) Int. Cl.: H01L 39/24, H01L 39/14

(54) **Brin supraconducteur à haute température critique (HTc), méthode de fabrication d'un tel brin**

(30) Priorité: 06.05.1999 FR 9905765
(71) Demandeur: ALCATEL, 75008 Paris (FR)
(72) Inventeur: Herrmann, Peter Friedrich, 91410 Corbreuse (FR); Duperray, Gérard, 91290 La Norville (FR); Leriche, Albert, 91190 Gif-sur-Yvette (FR); Tavergnier, Jean-Pierre, 91310 Linas (FR)
(74) Mandataire: Vigand, Privat

(57) **Abrégé**

L'invention concerne un procédé de fabrication du type poudre en tube d'un conducteur multifilamentaire (1) supraconducteur HTc à matrice (15) d'alliage d'Argent compatible (2), dans lequel :
lors de la réalisation de la billette multifilamentaire (12), on adapte le nombre de tronçons (11) par couche de manière à ce que, en coupe transversale, l'ensemble des couches de tronçons (11) ait une forme générale d'ensemble convergent-divergent (6), le col (7) du convergent-divergent (6) étant sensiblement contenu dans ledit plan médian de superposition (4); et en ce que lors des traitements mecaniques de ladite billette multifilamentaire (12), précédent les traitements thermiques de synthèse, on applique une force de laminage dans une direction (13) perpendiculaire au plan médian de superposition (4), et on coupe au moins un des bords (14) de la billette laminée, perpendiculaire au plan médian de superposition (4), mettant à jour la matrice (15) d'alliage d'Argent compatible (2).

## Description

L'invention concerne un brin supraconducteur à Haute Température critique (HTc), une méthode de fabrication d'un tel brin.

L'invention concerne plus particulièrement les brins supraconducteurs à Haute Température critique (HTc) fabriqués selon la méthode dite "poudre en tube" (Powder In Tube ou PIT).

La technique PIT est connue par elle-même et consiste, dans une première étape, à densifier des précurseurs de supraconducteur HTc dans un tube métallique. Dans une seconde étape, la billette ainsi réalisée est déformée, par exemple par tréfilage, pour obtenir un brin dit monofilamentaire. Dans une troisième étape, ce brin monofilamentaire est tronçonné et arrangé dans une nouvelle enveloppe métallique formant ainsi une billette multifilamentaire. Cette nouvelle billette multifilamentaire est, elle aussi, déformée et mise en forme jusqu'à obtenir un brin multifilamentaire aux dimensions et à la forme voulues. Au cours de ces étapes de fabrication, et dans le but de transformer les précurseurs en phase supraconductrice HTc il est nécessaire d'effectuer plusieurs traitements thermiques de transformation et plusieurs laminages intermédiaires de réactivation des précurseurs. On sait que le matériau constitutif du tube ou de l'enveloppe doit être suffisamment ductile pour pouvoir subir les différentes phases d'étirages et de laminage, et avoir une composition inerte ou du moins sans conséquences pour le traitement thermique de transformation des précurseurs de supraconducteur HTc en phase supraconductrice. Ce matériau doit être non polluant pour les précurseurs, et suffisamment perméable à l'oxygène pour laisser passer l'oxygène nécessaire à la bonne synthèse des précurseurs. Il est connu d'utiliser l'Argent pur ou un mélange d'alliage d'Argent compatible (par exemple AgPa) comme matériau constitutif des billettes.

Dans la suite de la description, on utilisera la terminologie "alliage d'Argent compatible" pour parler d'un alliage d'argent compatible avec la phase de synthèse des précurseurs, c'est à dire non polluant et perméable à l'oxygène.

Certaines applications utilisant des brins multifilamentaires supraconducteurs HTc demandent des longueurs conséquentes continues (par exemple bobines supraconductrice). Cela nécessite des méthodes de fabrication qui permettent d'obtenir de grandes longueurs de brin où les performances électriques et mécaniques du brin sont maintenues sur toute la longueur (notamment la phase supraconductrice).

FR 2 752 327 concerne un procédé de fabrication d'un brin multifilamentaire supraconducteur HTc à matrice d'alliage d'Argent compatible du type poudre en tube, dans lequel :
on réalise un monofilament de section carrée ou rectangulaire, ayant une gaine d'alliage d'Argent compatible et un coeur de précurseurs de supraconducteur HTc;
on tronçonne ledit monofilament et on arrange les tronçons résultant dans une enveloppe d'alliage d'Argent compatible de section carrée ou rectangulaire, réalisant ainsi une billette multifilamentaire ;
on applique les traitements thermiques et mécaniques pour obtenir la transformation des précurseurs en phase supraconductrice HTc et la forme définitive du brin multifilamentaire.

Lors de la réalisation de la billette multifilamentaire, on arrange les tronçons de monofilament couche par couche dans l'enveloppe, chaque couche étant décalée par rapport à la précédente, de manière à former un arrangement en quinconce des tronçons dans une direction perpendiculaire au plan des couches.

Les avantages résultant de l'agencement selon FR 2 752 327, sont une densification homogène des filaments, un taux de déformation supérieur de la phase supraconductrice, un écoulement homogène de l'argent réduisant les variations de section du brin. De ce fait, on obtient une bonne maîtrise des grandes longueurs en diminuant le nombre de défaut pouvant provoquer des ruptures en cours de fabrication. Le matériau d'alliage d'Argent compatible utilisé est compatible avec la phase de synthèse des précurseurs.

Cependant, un tel brin demeure fragile car le matériau d'alliage d'Argent compatible utilisé n'a pas une tenue mécanique importante. Il en résulte des déchirures dans la gaine extérieure du brin qui en affectent sensiblement les propriétés.

En outre, du fait des actions de laminage, il y a des parties du brin multifilamentaire, notamment dans les extrémités du brin rectangulaire, où la densité de filament supraconducteur est très faible. Cela participe aux mauvaises performance de densité de courant Jₑ (Engineer Current Density) défini comme le rapport du courant circulant dans le brin sur la surface transversale totale dudit brin.

Pour pallier les problèmes de tenue mécanique du brin multifilamentaire HTc, il est connu d'utiliser des alliages d'argent tels que AgMg ou AgCu.

Cependant:
- D'une part, ces matériaux sont polluant pour les précurseurs et ne peuvent donc être utilisé que comme enveloppe externe du brin, la matrice étant en Argent pur ou d'alliage d'Argent compatible ( par exemple AgPa).
- D'autre part, ces alliages d'Argent, nécessaires pour maintenir les performances mécaniques du brin, ne sont pas suffisamment perméable à l'oxygène pour assurer une synthèse optimale de la phase supraconductrice du brin. Il en résulte un brin, certes de bonne tenue mécanique, mais présentant de mauvaises caractéristiques électriques.

Dans la suite de la description, on utilisera la terminologie "alliage d'Argent non compatible" pour parler d'un alliage d'argent non compatible avec la phase de synthèse des précurseurs, c'est à dire soit polluant, soit peu perméable à l'oxygène.

L'un des buts de la présente invention est de proposer un procédé de fabrication d'un brin multifilamentaire HTc permettant d'obtenir conjointement une tenue mécanique améliorée, une synthèse optimale de la phase supraconductrice, et une densité de courant Jₑ accrue.

Un autre but de la présente invention est de proposer un brin multifilamentaire HTc de grande longueur présentant des performances électriques et de résistance mécanique améliorées.

A cet effet, l'invention concerne un procédé de fabrication du type poudre en tube d'un conducteur multifilamentaire supraconducteur HTc à matrice d'alliage d'Argent compatible, dans lequel :
on fabrique un monofilament de section carrée ou rectangulaire, ayant une gaine d'alliage d'Argent compatible et un coeur de précurseurs de supraconducteur HTc;
on tronçonne ledit monofilament et on remplit une enveloppe en alliage d'argent non compatible de section carrée ou rectangulaire avec les tronçons résultants, les tronçons étant disposés en couches superposées et centrées dans l'enveloppe en alliage d'argent non compatible, chaque couche étant décalée par rapport à la précédente, de manière à former un arrangement en quinconce des tronçons dans une direction perpendiculaire au plan des couches; on comble les espaces, laissés par les décalages en début et en fin de couche, par des barreaux d'alliage d'Argent compatible, réalisant ainsi une billette multifilamentaire présentant une symétrie par rapport à un plan médian de superposition;
on applique les traitements mécaniques et thermiques pour obtenir respectivement la forme définitive du brin multifilamentaire et la synthèse des précurseurs en phase supraconductrice HTc;
selon l'invention, lors de la réalisation de la billette multifilamentaire, on adapte le nombre de tronçons par couche de manière à ce que, en coupe transversale, l'ensemble des couches de tronçons ait une forme générale d'ensemble convergent-divergent, le col du convergent-divergent étant sensiblement contenue dans ledit plan médian de superposition; et
lors des traitements mécaniques de ladite billette multifilamentaire, précédant les traitements thermiques de synthèse, on applique une force de laminage dans une direction perpendiculaire au plan médian de superposition, et on coupe au moins un des bords de la biellette laminée, perpendiculaire au plan médian de superposition, mettant à jour la matrice d'alliage d'Argent compatible.

Avantageusement, pour limiter les contraintes dues au laminage, les traitements mécaniques comprennent des étapes thermiques de relaxation des contraintes.

Les deux bords, perpendiculaires au plan médian de superposition, peuvent être coupés .

L'invention concerne aussi un brin multifilamentaire à matrice d'alliage d'Argent compatible de forme générale rectangulaire, comprenant une pluralité de filaments supraconducteurs HTc, ayant une section transversale de forme générale rectangulaire, arrangés en quinconce couche par couche, deux cotés opposés de la forme rectangulaire étant recouverts d'une couche d'alliage d'argent non compatible.

Un premier avantage de la présente invention résulte de la forme générale d'ensemble convergent-divergent des monofilaments dans la billette de fabrication. une telle disposition permet de concentrer, après les étapes mécaniques de laminage du brin, les monofilaments dans la partie centrale du brin. Ainsi on obtient, dans la partie centrale du brin, une densité importante et homogène limitant la dispersion des monofilaments dans les extrémités transversales du brin.

Un autre avantage de la présente invention résulte de la combinaison de l'utilisation d'un matériau d'alliage d'Argent non compatible comme gaine extérieure du brin et de l'étape de coupe d'au moins un des bords de la billette laminée mettant à jour la matrice d'alliage d'Argent compatible. L'alliage d'Argent non compatible assure une bonne tenue mécanique du brin, et la mise à jour de la matrice d'alliage d'Argent compatible assure une bonne synthèse des précurseurs. Le résultat est un brin ayant des performances mécaniques et électriques améliorés.

Un avantage connexe du précédent résulte du fait que le surplus de matrice d'alliage d'Argent compatible, pauvre en monofilament, résultant du laminage et localisé dans les extrémités transversales du brin, est retiré lors de l'étape de coupe. Cela améliore sensiblement la densité de courant Jₑ.

D'autres avantages et caractéristiques de la présente invention résulteront de la description qui va suivre en référence aux dessins annexés dans lesquels :

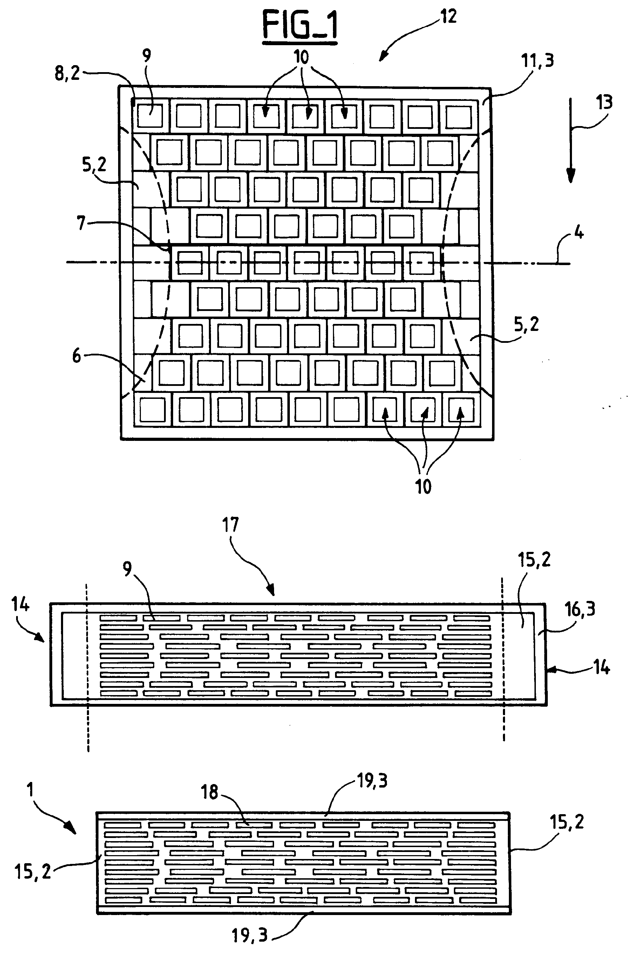

La figure 1 est un diagramme représentant schématiquement une partie des étapes du procédé selon la présente invention.

Les figures 2A à 2E sont des représentations schématiques en coupe transversale de billettes multifilamentaires pouvant être utilisées dans le procédé selon la présente invention.

La présente invention concerne un procédé de fabrication du type poudre en tube d'un conducteur multifilamentaire supraconducteur HTc 1 à matrice 15 d'alliage d'Argent compatible 2.

Les étapes du procédé sont les suivantes :

On fabrique un monofilament de section carrée ou rectangulaire, ayant une gaine 8 d'alliage d'Argent compatible 2 et un coeur de précurseurs de supraconducteur HTc 9. Le monofilament est fabriqué à partir d'une billette comprenant une enveloppe en alliage d'argent compatible remplie de précurseurs. La billette est alors traitée mécaniquement par étirage et laminage pour obtenir le monofilament.

On tronçonne le monofilament et on remplit une enveloppe 11 en alliage d'argent non compatible 3 de section carrée ou rectangulaire avec les tronçons 10 de monofilaments.

Les tronçons 10 sont disposés en couches superposées et centrées dans l'enveloppe 11 en alliage d'argent non compatible 3, chaque couche étant décalée par rapport à la précédente, de manière à former un arrangement en quinconce des tronçons 10 dans une direction 13 perpendiculaire au plan 4 des couches.

En outre, le nombre de tronçons 10 par couche est adapté pour, qu'en coupe transversale de la billette 12, l'ensemble des couches de tronçons 10 ait une forme générale d'ensemble convergent-divergent 6.

Le col 7 du convergent-divergent 6 étant sensiblement contenue dans un plan médian de superposition 4 défini comme parallèle aux couches de tronçons 10 et médian de l'enveloppe 11.

Afin de compléter le remplissage de l'enveloppe 11, on comble les espaces, laissés par les décalages en début et en fin de couche, par des barreaux 5 d'alliage d'Argent compatible 2, réalisant ainsi une billette multifilamentaire 12 présentant une symétrie par rapport au plan médian de superposition 4.

On applique des traitements mécaniques pour obtenir la forme définitive du brin multifilamentaire. Ces traitements mécaniques consistent notamment en un laminage de la billette dans la direction 13 perpendiculaire au plan médian 4.

Du fait de l'agencement initial des tronçons 10 de monofilament dans la billette 12, et en choisissant judicieusement la largeur du brin multifilamentaire, à l'issue des traitements mécaniques, on obtient un brin multifilamentaire présentant, une gaine 16 en alliage d'argent non compatible 3, une matrice 15 d'alliage d'argent compatible 2, et des filaments de précurseurs 9, noyés dans la matrice 15 d'alliage d'argent compatible 2, concentrés dans la partie centrale 17 du brin, les deux extrémités 14 du brin étant exemptes ou du moins pauvres en filaments de précurseurs 9.

Afin de relâcher les contraintes mécaniques résultant des traitements mécaniques du brin, il peut être prévu une étape thermique de relaxation des contraintes.

On coupe au moins une des extrémités 14 du brin, perpendiculairement au plan médian de superposition 4. Cette étape du procédé permet de mettre à jour la matrice 15 d'alliage d'Argent compatible 2, assurant au moins une fenêtre de matériau perméable à l'oxygène en vu de l'étape de synthèse supraconductrice. Avantageusement on coupera les deux extrémités 14 du brin afin d'obtenir deux fenêtres d'oxygénation.

On effectue alors la synthèse des précurseurs en phase supraconductrice HTc grâce à une étape thermique dans laquelle :
- les précurseurs des filaments sont parfaitement synthétises en matériau supraconducteur HTc, l'oxygène nécessaire à la synthèse étant absorbée par les fenêtres d'oxygénation.
- l'alliage d'argent non compatible 3 est sensiblement durci, assurant de ce fait une résistance mécanique améliorée du brin multifilamentaire supraconducteur HTc.

La concentration des filaments dans la partie centrale du brin, et le fait que les extrémités 14 pauvres en filaments aient été retirées, assurent une excellente densité de courant Jₑ.

L'invention concerne aussi un brin multifilamentaire à matrice 15 d'alliage d'Argent compatible 2 de forme générale rectangulaire, comprenant une pluralité de filaments supraconducteurs HTc 18, ayant une section transversale de forme générale rectangulaire arrangés en quinconce couche par couche, deux cotés opposés de la forme rectangulaire étant recouverts d'une couche 19 d'alliage d'argent non compatible 3.

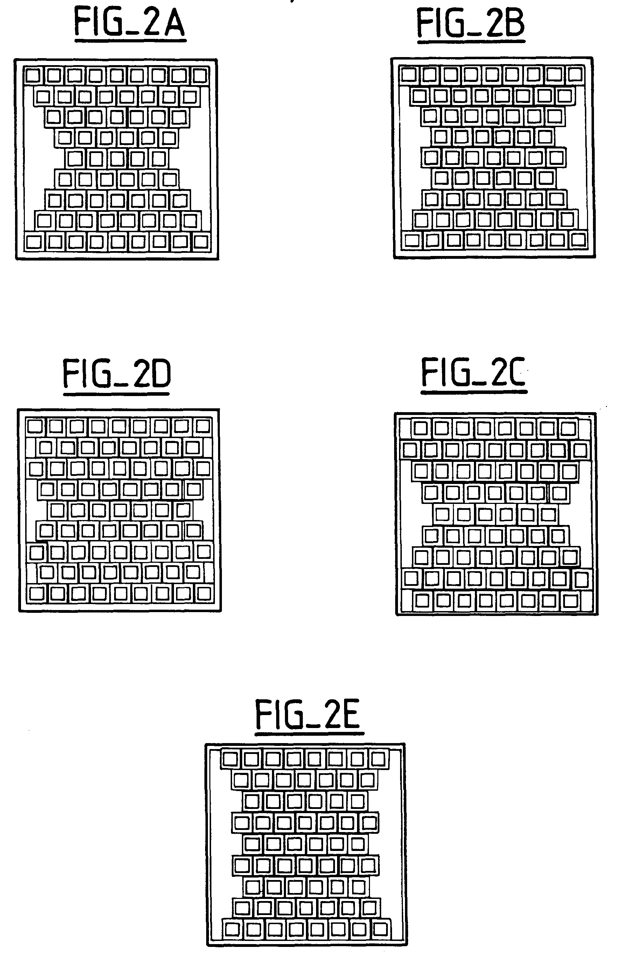

Les figures 2A à 2E sont des exemples d'arrangement des tronçons 10 de monofilament dans la billette multifilamentaire 12.

La figure 2A est une représentation d'une billette multifilamentaire ayant un design 4x8+5x9 soit 78 tronçons. 12 tronçons ont été remplacés selon une séquence en couche 9-8-7-6-5-6-7-8-9, reste donc 66 tronçons. Par rapport à un brin 78 filaments, le brin 66 filaments présente une largeur inférieure de 30% correspondant aux extrémités retirées, et une augmentation de Jₑ de 20%.

Les figures 2B, 2C, 2D présentent des billettes multifilamentaires ayant un design 4x8+5x9 soit 78 tronçons où respectivement 2, 6, 10 tronçons ont été remplacés.

La figure 2E présente une billette multifilamentaire ayant un design 5x8+4x9 soit 76 tronçons où 14 tronçons ont été remplacés. Par rapport à un brin 76 filaments, le brin 62 filament présente une largeur inférieure de 30% correspondant aux extrémités retirées, et une augmentation de Jₑ de 17%.

## Revendications

1. Procédé de fabrication du type poudre en tube d'un conducteur multifilamentaire (1 ) supraconducteur HTc à matrice (15) d'alliage d'Argent compatible (2), dans lequel :
on fabrique un monofilament de section carrée ou rectangulaire, ayant une gaine (8) d'alliage d'Argent compatible (3) et un coeur de précurseurs de supraconducteur HTc (9);
on tronçonne ledit monofilament et on remplit une enveloppe (11) en alliage d'argent non compatible (3) de section carrée ou rectangulaire avec les tronçons (10) résultants, les tronçons (10) étant disposés en couches superposées et centrées dans l'enveloppe (11) en alliage d'argent non compatible (3), chaque couche étant décalée par rapport à la précédente, de manière à former un arrangement en quinconce des tronçons (10); on comble les espaces, laissés par les décalages en début et en fin de couche, par des barreaux (5) d'alliage d'Argent compatible (2), réalisant ainsi une billette multifilamentaire (12) présentant une symétrie par rapport à un plan médian de superposition (4); on applique les traitements mécaniques et thermiques pour obtenir respectivement la forme définitive du brin multifilamentaire (1) et la synthèse des précurseurs (9) en phase supraconductrice HTc;
caractérisé en ce que lors de la réalisation de la billette multifilamentaire (12), on adapte le nombre de tronçons (11) par couche de manière à ce que, en coupe transversale, l'ensemble des couches de tronçons (11) ait une forme générale d'ensemble convergent-divergent (6), le col (7) du convergent-divergent (6) étant sensiblement contenu dans ledit plan médian de superposition (4); et en ce que lors des traitements mécaniques de ladite billette multifilamentaire (12), précédent les traitements thermiques de synthèse, on applique une force de laminage dans une direction (13) perpendiculaire au plan médian de superposition (4), et on coupe au moins un des bords (14) de la biellette laminée, perpendiculaire au plan médian de superposition (4), mettant à jour la matrice (15) d'alliage d'Argent compatible (2).

2. Procédé de fabrication selon la revendication 1 caractérisé en ce que les traitements mécaniques comprennent des étapes thermiques de relaxation des contraintes.

3. Procédé de fabrication selon la revendication 1 ou 2 caractérisé en ce que les deux bords (14), perpendiculaires au plan médian de superposition (4), sont coupés.

4. Brin multifilamentaire à matrice (15) d'alliage d'Argent compatible (2) de forme générale rectangulaire, comprenant une pluralité de filaments supraconducteurs HTc (18), ayant une section transversale de forme générale rectangulaire, arrangés en quinconce couche par couche, caractérisé en ce que deux cotés opposés de la forme rectangulaire dudit brin multifilamentaire sont recouverts d'une couche (19) d'alliage d'argent non compatible (3)
